(19) Europäisches Patentamt
European Patent Office
Office européen des brevets

(11) EP 3 288 051 A1

(12) **EUROPEAN PATENT APPLICATION**
published in accordance with Art. 153(4) EPC

(43) Date of publication:
**28.02.2018 Bulletin 2018/09**

(21) Application number: **16783174.2**

(22) Date of filing: **20.04.2016**

(51) Int Cl.:
***H01G 9/20*** *(2006.01)*

(86) International application number:
**PCT/JP2016/062453**

(87) International publication number:
**WO 2016/171153 (27.10.2016 Gazette 2016/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **21.04.2015 JP 2015086944**

(71) Applicant: **Sumitomo Seika Chemicals Co., Ltd.**
**Kako-gun, Hyogo 675-0145 (JP)**

(72) Inventors:
- **HASHIMOTO, Shun**
  **Himeji-shi**
  **Hyogo 672-8076 (JP)**
- **KONO, Yuki**
  **Kako-gun**
  **Hyogo 675-0145 (JP)**
- **KINPARA, Yuji**
  **Himeji-shi**
  **Hyogo 672-8076 (JP)**
- **FUJITA, Koji**
  **Kako-gun**
  **Hyogo 675-0145 (JP)**

(74) Representative: **Webster, Jeremy Mark et al**
**Mewburn Ellis LLP**
**City Tower**
**40 Basinghall Street**
**London EC2V 5DE (GB)**

(54) **DYE-SENSITIZED SOLAR CELL AND ELECTROLYSIS SOLUTION FOR DYE-SENSITIZED SOLAR CELL**

(57) Provided is a dye-sensitized solar cell that is non-iodine based, that has superior diffusivity of a charge-transporting material, and that has long-term stable cell performance. The dye-sensitized solar cell is provided with a semiconductor electrode including a semiconductor and a dye, a counter electrode facing the semiconductor electrode, and an electrolyte layer provided between the semiconductor electrode and the counter electrode, wherein the electrolyte layer contains a nitroxyl radical compound and a sulfone compound represented by formula (1). [In formula (1), $R^1$ and $R^2$ independently represent a straight-chain or branched-chain alkyl group with a carbon number of 1-12, an alkoxy group, an aromatic ring, or a halogen, or alternatively, $R^1$ and $R^2$ are bonded to each other to form a ring-shaped sulfone compound.]

EP 3 288 051 A1

## Description

### TECHNICAL FIELD

The present invention relates to a dye-sensitized solar cell, and an electrolytic solution used in a dye-sensitized solar cell.

### BACKGROUND ART

In recent years, techniques of utilizing wind power, sunlight, and the like as renewable energy have been extensively studied. Among others, a photoelectric conversion technique such as a solar cell is one of techniques that have attracted attention since such a technique enables use of renewable energy in general household.

Examples of forms of solar cells based on a photoelectric conversion technique include crystalline silicon solar cells, amorphous silicon solar cells, organic thin film solar cells, and dye-sensitized solar cells as classified based on the device material, for example. Of these, crystalline silicon solar cells have been industrially produced from a long time ago, and are beginning to be popularized with the recent improvement in conversion efficiency. In addition, from the viewpoint of price and material supply, various solar cells that can supersede crystalline silicon solar cells are being vigorously studied.

As an example of various solar cells that can supersede crystalline silicon solar cells, a dye-sensitized solar cell can be mentioned. A dye-sensitized solar cell is a solar cell proposed by Gratzel et al. at Ecole Polytechnique Federale de Lausanne in 1991, and includes a semiconductor electrode made of a porous metal oxide, such as titanium oxide, carrying a dye such as a ruthenium complex. Dye-sensitized solar cells have been studied particularly actively due to their high photoelectric conversion efficiency and low cost of raw materials (see, for example, Non-Patent Document 1 and Patent Document 1).

Dye-sensitized solar cells are difficult to be made large due to their complicated manufacturing process. In addition, since the electrolyte of the dye-sensitized solar cells contains iodine, a metal part such as a current collector is required to have corrosion durability. Furthermore, in the pores of the semiconductor carrying a dye, there are portions where the semiconductor is exposed. In these portions, electrons transferred from the dye to the semiconductor react with iodine, that is, the electrolyte (reverse electron transfer reaction) to adversely cause loss of voltage and current. To solve these problems, the following various proposals have been made: to use a corrosion-resistant current collector such as platinum (see, for example, Patent Document 2), to reform a semiconductor layer (see, for example, Patent Documents 3 and 4), and to gelate the electrolyte (see, for example, Patent Document 5).

These conventional methods, however, still employ halogen ions such as iodine in the electrolyte. Moreover, only limited electrodes such as platinum can be used from the viewpoint of corrosion resistance of the electrode, and a material that is inexpensive and excellent in conductivity, such as aluminum and copper, cannot be used.

In addition, a technique of using a nitroxy radical compound instead of iodine in the electrolyte has also been proposed (Patent Document 6). In such technique, however, an organic solvent such as acetonitrile is generally used as a solvent of the electrolytic solution. Organic solvents such as acetonitrile are generally highly volatile and likely to generate a gas due to volatilization or decomposition in the cell. For this reason, such a solvent may cause deterioration of cell characteristics such as reduction in current density and open circuit voltage due to long-term use. In addition, the method of gelation of the electrolyte may lower the diffusibility of the charge-transporting material, which may result in a reduction in current and voltage.

Under such circumstances, it is desired to develop a dye-sensitized solar cell that is non-iodine-based, excellent in diffusibility of a charge-transporting material, and stabilized in cell characteristics over a long period of time.

### PRIOR ART DOCUMENTS

### PATENT DOCUMENTS

Patent Document 1: Japanese Patent Laid-open Publication No. 1-220380
Patent Document 2: Published Japanese Translation No. 2010-508636
Patent Document 3: Japanese Patent Laid-open Publication No. 2000-285974
Patent Document 4: Japanese Patent Laid-open Publication No. 2001-35551
Patent Document 5: Japanese Patent Laid-open Publication No. 2002-363418
Patent Document 6: Japanese Patent Laid-open Publication No. 2009-76369

NON-PATENT DOCUMENT

Non-Patent Document 1: B. O'Regan and M. Gratzel, Nature, 353(24), 737, 1991

## SUMMARY OF THE INVENTION

## PROBLEMS TO BE SOLVED BY THE INVENTION

A primary object of the present invention is to provide a dye-sensitized solar cell that is non-iodine-based, excellent in diffusibility of a charge-transporting material, and stabilized in cell characteristics over a long period of time. Another object of the present invention is to provide an electrolytic solution that is non-iodine-based and excellent in diffusibility of a charge-transporting material, and is capable of stabilizing cell characteristics of a dye-sensitized solar cell over a long period of time.

## MEANS FOR SOLVING THE PROBLEMS

The present inventors conducted intensive studies to solve the above-mentioned problems. As a result, they found that an electrolytic solution for a dye-sensitized solar cell that contains a specific nitroxyl radical compound as a charge-transporting material and a specific sulfone compound as a solvent is excellent in diffusibility of a charge-transporting material although the electrolytic solution is non-iodine-based, and is capable of stabilizing cell characteristics of a dye-sensitized solar cell over a long period of time. The present invention has been completed based on such finding and further investigation.
That is, the present invention provides the following inventions.

Item 1. A dye-sensitized solar cell including:

a semiconductor electrode containing a semiconductor and a dye,
a counter electrode opposed to the semiconductor electrode, and
an electrolyte layer provided between the semiconductor electrode and the counter electrode,
wherein the electrolyte layer contains a nitroxyl radical compound, and a sulfone compound represented by the following formula (1):

[Chemical Formula 1]

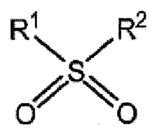

(1)

wherein $R^1$ and $R^2$ are each independently a linear or branched alkyl group having 1 to 12 carbon atoms, an alkoxy group, an aromatic ring, or a halogen, or $R^1$ and $R^2$ are mutually linked to form a cyclic sulfone compound.

Item 2. The dye-sensitized solar cell according to item 1, wherein the nitroxyl radical compound is a nitroxyl radical compound represented by the following formula (2):

[Chemical Formula 2]

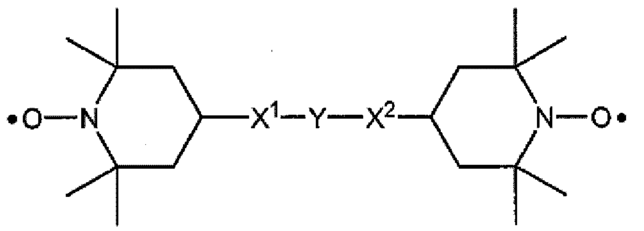

(2)

wherein $X^1$ represents a group $-(CH_2)_{n1}-OC(=O)-$, a group $-(CH_2)_{n1}-C(=O)O-$, or a group -O-, $X^2$ represents a group

$-C(=O)O-(CH_2)_{n2}-$, a group $-OC(=O)-(CH_2)_{n2}-$, or a group -O-, n1 and n2 each independently represent an integer of 0 to 10, Y represents a group $-(CH_2)_{n3}-$ or a group $-(CH_2CH_2O)_{n4}-CH_2CH_2-$, and n3 and n4 each represent an integer of 0 to 22.

Item 3. The dye-sensitized solar cell according to item 2, wherein the nitroxyl radical compound represented by the formula (2) has a molecular weight of 380 or more.

Item 4. The dye-sensitized solar cell according to item 2 or 3, wherein, in the formula (2), $X^1$ represents a group $-(CH_2)_{n1}-OC(=O)-$, $X^2$ represents a group $-C(=O)O-(CH_2)_{n2}-$, Y represents a group $-(CH_2)_{n3}-$, n1 and n2 each independently represent an integer of 0 to 10, and n3 represents an integer of 0 to 22.

Item 5. The dye-sensitized solar cell according to item 2 or 3, wherein, in the formula (2), $X^1$ represents a group $-(CH_2)_{n1}-C(=O)O-$, $X^2$ represents a group $-OC(=O)-(CH_2)_{n2}-$, Y represents a group $-(CH_2CH_2O)_{n4}-CH_2CH_2-$, n1 and n2 each independently represent an integer of 0 to 10, and n4 represents an integer of 1 to 22.

Item 6. The dye-sensitized solar cell according to item 1, wherein the nitroxyl radical compound is a nitroxyl radical compound represented by the following formula (3):

[Chemical Formula 3]

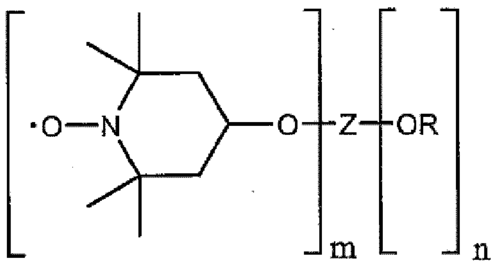

(3)

wherein Z represents a P atom or a Si atom, and n number of R's each independently represent an H atom, R's each independently represent an H atom, an alkyl group having 1 to 18 carbon atoms, or a 2,2,6,6-tetramethylpiperidine-1-oxyl-4-yl group, m represents an integer of 1 to 4, n represents an integer of 0 to 3, and when Z is a P atom, n + m = 3, and when Z is a Si atom, n + m = 4.

Item 7. The dye-sensitized solar cell according to item 6, wherein, in the formula (3), Z is a P atom and m is 3.

Item 8. The dye-sensitized solar cell according to item 6, wherein, in the formula (3), Z is a Si atom, m is 3 or 4, and when m is 3, R is an H atom.

Item 9. An electrolytic solution for a dye-sensitized solar cell, containing:

a nitroxyl radical compound, and
a sulfone compound represented by the following formula (1):

[Chemical Formula 4]

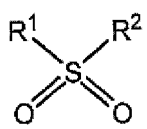

(1)

wherein $R^1$ and $R^2$ are each independently a linear or branched alkyl group having 1 to 12 carbon atoms, an alkoxy group, an aromatic ring, or a halogen, or $R^1$ and $R^2$ are mutually linked to form a cyclic sulfone compound.

ADVANTAGES OF THE INVENTION

According to the present invention, it is possible to provide a dye-sensitized solar cell that is non-iodine-based, excellent in diffusibility of a charge-transporting material, and stabilized in cell characteristics over a long period of time. Further, according to the present invention, it is possible to provide an electrolytic solution for a dye-sensitized solar cell that is non-iodine-based and excellent in diffusibility of a charge-transporting material, and is capable of stabilizing cell characteristics of a dye-sensitized solar cell over a long period of time.

Specifically, as shown in the formulae (2) and (3), the charge-transporting material used in the electrolytic

solution for a dye-sensitized solar cell of the present invention is designed to contain a 2,2,6,6-tetramethylpiperidine-1-oxyl-4-yl group (radical unit), and have a small molecular weight of the nitroxyl radical compound as a whole and a bulky steric structure of the molecule owing to a specific structure of a group that links the radical unit. Therefore, when such a charge-transporting material is used in the electrolyte of the dye-sensitized solar cell, the decrease in the diffusion rate due to the increase in the molecular weight is effectively suppressed. Further, the nitroxyl radical represented by the formula (2) or (3) is suppressed in sublimation, decomposition and the like, has high thermal stability, and can contribute to the durability of the dye-sensitized solar cell. Furthermore, as described above, it is known that in the conventional dye-sensitized solar cells, there are portions where the semiconductor is exposed in the pores of the semiconductor carrying a dye, and in these portions, the semiconductor and the electrolyte undergo a reverse electron transfer reaction to cause loss of voltage and current. In the present invention, however, incorporation of the charge-transporting material into the pores of the semiconductor due to the bulkiness of the charge-transporting material is suppressed, and the occurrence of the reverse electron transfer reaction is reduced. Therefore, use of the charge-transporting material in the electrolyte layer of the dye-sensitized solar cell can impart excellent cell characteristics to the dye-sensitized solar cell. Furthermore, since the charge-transporting material used in the present invention is non-iodine-based, use of the charge-transporting material in an electrolyte layer of a dye-sensitized solar cell eliminates the necessity of use of an expensive metal such as platinum in a current collector or the like, so that it is possible to manufacture a dye-sensitized solar cell at a lower cost.

In the electrolytic solution for a dye-sensitized solar cell of the present invention, a specific sulfone compound represented by the formula (1) is used as a solvent. The sulfone compound is excellent in thermal stability, has high decomposition voltage characteristics, and does not evaporate in a large amount at high temperatures. Therefore, the sulfone compound contributes to the long-term stability of the dye-sensitized solar cell.

As described above, in the dye-sensitized solar cell of the present invention, use of the specific nitroxyl radical compound as a charge-transporting material of the electrolytic solution as well as use of the specific sulfone compound as a solvent makes the electrolytic solution excellent in diffusibility of the charge-transporting material although the electrolytic solution is non-iodine-based, and also makes the electrolytic solution capable of stabilizing cell characteristics of the dye-sensitized solar cell over a long period of time.

EMBODIMENTS OF THE INVENTION

The dye-sensitized solar cell of the present invention includes a semiconductor electrode containing a semiconductor and a dye, a counter electrode opposed to the semiconductor electrode, and an electrolyte layer provided between the semiconductor electrode and the counter electrode, and the electrolyte layer contains a sulfone compound represented by the formula (1) and a nitroxyl radical compound.

Further, the electrolytic solution for a dye-sensitized solar cell of the present invention can be used, for example, in the electrolyte layer of the dye-sensitized solar cell of the present invention, and contains the sulfone compound represented by the formula (1) and the nitroxyl radical compound.

Hereinafter, the electrolytic solution for a dye-sensitized solar cell, and the dye-sensitized solar cell of the present invention will be described in detail.

1. Electrolytic solution for dye-sensitized solar cell

The electrolytic solution for a dye-sensitized solar cell of the present invention contains a sulfone compound represented by the following formula (1) as a solvent. Use of a nitroxyl radical compound as a charge-transporting material and the specific sulfone compound as a solvent in the electrolytic solution of the present invention can broaden and stabilize the potential window, and exponentially improve the long-term stability of cell characteristics of the dye-sensitized solar cell.

[Chemical Formula 5]

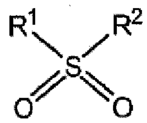

(1)

In the formula (1), $R^1$ and $R^2$ are each independently a linear or branched alkyl group having 1 to 12 carbon atoms, an alkoxy group, an aromatic ring, or a halogen, or $R^1$ and $R^2$ are mutually linked to form a cyclic sulfone compound. In the electrolytic solution for a dye-sensitized solar cell of the present invention, one type of sulfone compound

may be used alone, or two or more types thereof may be used in combination.

Specific examples of the sulfone compound include dimethyl sulfone, ethyl methyl sulfone, diethyl sulfone, propyl methyl sulfone, isopropyl methyl sulfone, propyl ethyl sulfone, isopropyl ethyl sulfone, dipropyl sulfone, diisopropyl sulfone, ethyl isobutyl sulfone, isobutyl isopropyl sulfone, methoxyethyl isopropyl sulfone, and fluoroethyl isopropyl sulfone. Among them, sulfone compounds having a total number of carbon atoms of $R^1$ and $R^2$ of 5 or more, preferably 5 to 10, such as ethyl isopropyl sulfone, ethyl isobutyl sulfone, isobutyl isopropyl sulfone, methoxyethyl isopropyl sulfone, and fluoroethyl isopropyl sulfone are particularly suitable because they can be used in a wide temperature range, and are excellent in long-term reliability.

Another example of the sulfone compound is a compound in which at least one of $R^1$ and $R^2$ is a phenyl group, and examples thereof include phenyl isopropyl sulfone, phenylethyl sulfone, and diphenyl sulfone.

Examples of the cyclic sulfone compound include sulfolane, 3-methylsulfolane, 3-ethylsulfolane, 3-propylsulfolane, 3-butylsulfolane, 3-pentylsulfolane, 3-isopropylsulfolane, 3-isobutylsulfolane, and 3-isopentylsulfolane.

The electrolytic solution of the present invention may contain other organic solvents in addition to the above-mentioned sulfone compound as long as the effect of the present invention is not impaired. The organic solvent that can be used in combination with the sulfone compound is preferably an organic solvent that is electrochemically stable, low in viscosity, and has sufficient ion conductivity. Specific examples thereof include carbonates such as dimethyl carbonate, diethyl carbonate, ethylene carbonate, and propylene carbonate; alcohols such as methanol and ethanol; ethers such as tetrahydrofuran, dioxane, and diethyl ether; nitriles such as acetonitrile and benzonitrile; and aprotic polar solvents such as N,N-dimethylformamide, N-methylpyrrolidone, and dimethyl sulfoxide. As the organic solvent used in combination with the sulfone compound, one type of organic solvent may be used alone, or two or more types thereof may be used in combination. The content of the solvent used in combination in the entire solvents of the electrolytic solution of the present invention is preferably 90% by mass or less, more preferably 80% by mass or less.

The charge-transporting material contained in the electrolytic solution of the present invention is not particularly limited as long as it contains a nitroxyl radical compound, but preferably contains at least one of the nitroxyl radical compounds represented by the following formulae (2) and (3).

[Chemical Formula 6]

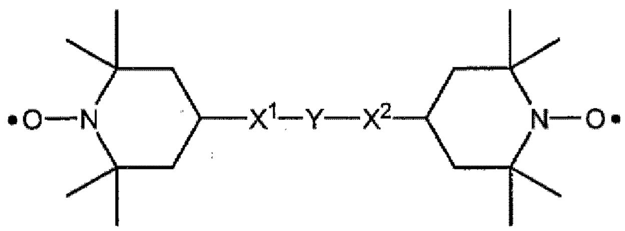

(2)

In the formula (2), $X^1$ represents a group $-(CH_2)_{n1}-OC(=O)-$, a group $-(CH_2)_{n1}-C(=O)O-$, or a group -O-. $X^2$ represents a group $-C(=O)O-(CH_2)_{n2}-$, a group $-OC(=O)-(CH_2)_{n2}-$, or a group -O-. n1 and n2 each independently represent an integer of 0 to 10. Y represents a group $-(CH_2)_{n3}-$ or a group $-(CH_2CH_2O)_{n4}-CH_2CH_2-$. n3 and n4 each represent an integer of 0 to 22. It is to be noted that, for example, in the group $-X^1-Y-X^2-$ of the formula (2), when both $X^1$ and $X^2$ are a group -O- and Y is a single bond, the group $-X^1-Y-X^2-$ is a group -O-O-, and thus, the compound represented by the formula (2) is generally unstable. Thus, in the formula (2), the group $-X^1-Y-X^2-$does not have to include the bond -O-O- because the group $-X^1-Y-X^2-$ including the bond -O-O- is generally unstable.

[Chemical Formula 7]

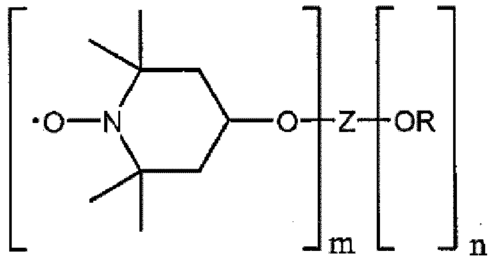

(3)

In the formula (3), Z represents a P atom or a Si atom. n number of R's each independently represent an H atom, R's each independently represent an H atom, an alkyl group having 1 to 18 carbon atoms, or a 2,2,6,6-tetramethylpiperidine-1-oxyl-4-yl group. m represents an integer of 1 to 4. n represents an integer of 0 to 3. When Z is a P atom, n + m = 3, and when Z is a Si atom, n + m = 4.

The upper limit of the molecular weight of the nitroxyl radical compound represented by the formula (2) or (3) is not particularly limited, but is preferably 1000 or less from the viewpoint of suppressing the reverse electron transfer reaction with the semiconductor while improving the stability of the nitroxyl radical compound in the electrolytic solution, and imparting excellent cell characteristics to a dye-sensitized solar cell. If the molecular weight is too large, it may become difficult to impart excellent cell characteristics to a dye-sensitized solar cell since the diffusibility of the charge-transporting material in the electrolytic solution lowers and the charge transporting efficiency per molecule is reduced, although the occurrence of the reverse electron transfer reaction in the semiconductor pores can be reduced.

The lower limit of the molecular weight of the nitroxyl radical compound represented by the formula (2) or (3) is not particularly limited, but is preferably 380 or more, more preferably 500 or more from the same viewpoint as described above. If the molecular weight is too small, the charge-transporting material easily enters the pores of the semiconductor, and a reverse electron transfer reaction from the semiconductor to the charge-transporting material is likely to occur, so that the current density is reduced, and it may become difficult to impart excellent cell characteristics to a dye-sensitized solar cell.

When the charge-transporting material used in the present invention is the nitroxyl radical compound represented by the formula (2), it is preferable that $X^1$ be a group $-(CH_2)_{n1}-OC(=O)-$, $X^2$ be a group $-C(=O)O-(CH_2)_{n2}-$, and Y be a group $-(CH_2)_{n3}-$in the formula (2) from the viewpoint of suppressing the reverse electron transfer reaction with the semiconductor while improving the diffusibility of the nitroxyl radical compound in the electrolytic solution, and imparting excellent cell characteristics to a dye-sensitized solar cell. That is, a preferable charge-transporting material in the present invention is a nitroxyl radical compound represented by the following formula (2a). In the formula (2a), n1 and n2 are each independently an integer of 0 to 10, and n3 is an integer of 0 to 22.

[Chemical Formula 8]

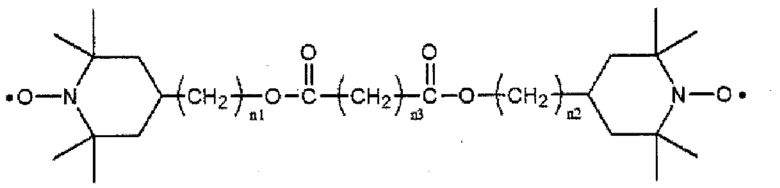

(2a)

When the charge-transporting material used in the present invention is the nitroxyl radical compound represented by the formula (2), it is preferable that $X^1$ be a group $-(CH_2)_{n1}-C(=O)O-$, $X^2$ be a group $-OC(=O)-(CH_2)_{n2}-$, Y be a group $-(CH_2CH_2O)_{n4}-CH_2CH_2-$, and n4 be an integer of 1 to 22 in the formula (2) from the viewpoint of suppressing the reverse electron transfer reaction with the semiconductor while improving the stability of the nitroxyl radical compound in the electrolytic solution, and imparting excellent cell characteristics to a dye-sensitized solar cell. That is, a preferable charge-transporting material in the present invention is a nitroxyl radical compound represented by the following formula (2b). In the formula (2b), n1 and n2 are each independently an integer of 0 to 10.

[Chemical Formula 9]

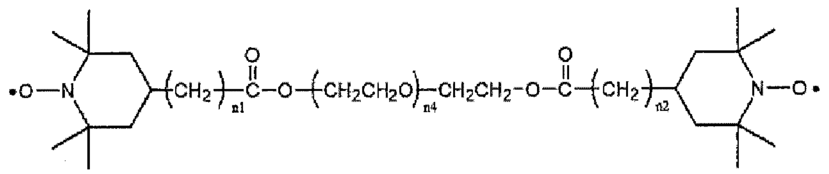

(2b)

When the charge-transporting material used in the present invention is the nitroxyl radical compound represented by the formula (3), it is preferable that m be an integer of 2 to 4, more preferably 3 or 4 in the formula (3) from the viewpoint of suppressing the reverse electron transfer reaction with the semiconductor while improving the stability of the nitroxyl radical compound in the electrolytic solution, and imparting excellent cell characteristics to a dye-sensitized solar cell. That is, in the nitroxyl radical compound represented by the formula (3), the number of TEMPO groups is preferably 2 to 4, more preferably 3 or 4.

When the charge-transporting material used in the present invention is the nitroxyl radical compound represented by the formula (3) and Z is a P atom, it is preferable that m be 3 in the formula (3) from the viewpoint of suppressing the reverse electron transfer reaction with the semiconductor while improving the stability of the nitroxyl radical compound in the electrolytic solution, and imparting excellent cell characteristics to a dye-sensitized solar cell. That is, a preferable charge-transporting material in the present invention is a nitroxyl radical compound represented by the following formula (3a).

[Chemical Formula 10]

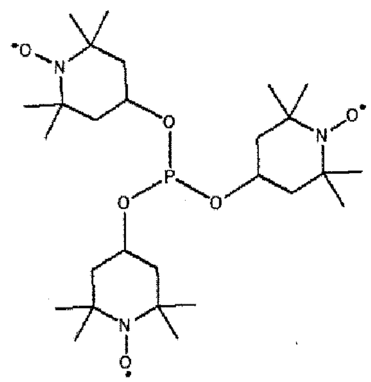

(3a)

When the charge-transporting material used in the present invention is the nitroxyl radical compound represented by the formula (3) and Z is a Si atom, it is preferable that m be 3 or 4 in the formula (3), and when m is 3, it is more preferable that R be an H atom from the viewpoint of suppressing the reverse electron transfer reaction with the semiconductor while improving the stability of the nitroxyl radical compound in the electrolytic solution, and imparting excellent cell characteristics to a dye-sensitized solar cell. That is, a preferable charge-transporting material in the present invention is a nitroxyl radical compound represented by the following formula (3b) or (3c).

[Chemical Formula 11]

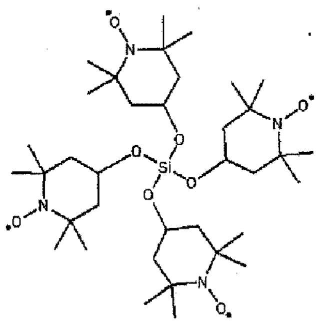 (3b) 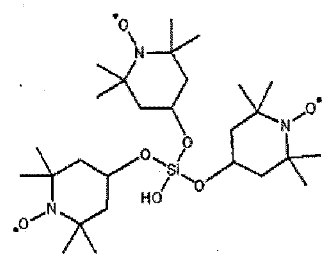 (3c)

A method for manufacturing the charge-transporting material used in the present invention is not particularly limited, and a known manufacturing method can be adopted. For example, the nitroxyl radical compound represented by the formula (2) that has 2 TEMPO groups per molecule can be synthesized by reacting a bifunctional compound with a functional group-containing 2,2,6,6-tetramethylpiperidine-1-oxyl compound (a functional group-containing TEMPO compound). The bifunctional compound is not particularly limited as long as it is a compound capable of introducing a TEMPO group, and examples thereof include a dicarboxylic acid and a dialcohol. The functional group-containing TEMPO compound is not particularly limited as long as it is capable of reacting with each of the two functional groups of the bifunctional compound to introduce two TEMPO compounds into the bifunctional compound. One type of each of the bifunctional compound and the functional group-containing TEMPO compound may be used alone, or two or more types thereof may be used in combination.

Specific examples of the dicarboxylic acid as the bifunctional compound include saturated hydrocarbon dicarboxylic acids such as oxalic acid, malonic acid, succinic acid, glutaric acid, adipic acid, pimelic acid, suberic acid, azelaic acid, sebacic acid, decanedicarboxylic acid, dodecyldicarboxylic acid, hexadecanedicarboxylic acid, and octadecanedicarboxylic acid; and polyethylene glycol dicarboxylic acids such as ethylene glycol dicarboxylic acid, diethylene glycol dicarboxylic acid, triethylene glycol dicarboxylic acid, tetraethylene glycol dicarboxylic acid, pentaethylene glycol dicarboxylic acid, hexaethylene glycol dicarboxylic acid, heptaethylene glycol dicarboxylic acid, octaethylene glycol dicarboxylic acid, and nonaethylene glycol dicarboxylic acid. Among them, saturated hydrocarbon dicarboxylic acids such as adipic acid, pimelic acid, suberic acid, azelaic acid, and sebacic acid; and polyethylene glycol dicarboxylic acids such as ethylene glycol dicarboxylic acid, triethylene glycol dicarboxylic acid, and tetraethylene glycol dicarboxylic acid are preferable from the viewpoint of solubility in an electrolytic solution described later that is used in a dye-sensitized solar cell, molecular size, and charge transporting efficiency.

Specific examples of the dialcohol as the bifunctional compound include saturated hydrocarbon diols such as ethanediol, propanediol, butanediol, pentanediol, hexanediol, heptanediol, octanediol, nonanediol, decanediol, undecanediol, dodecanediol, hexadecanediol, and octadecanediol; and polyethylene glycol diols such as ethylene glycol, diethylene glycol, triethylene glycol, tetraethylene glycol, pentaethylene glycol, hexaethylene glycol, heptaethylene glycol, octaethylene glycol, and nonaethylene glycol. Among them, saturated hydrocarbon diols such as butanediol, pentanediol, hexanediol, heptanediol, and octanediol; and polyethylene glycol diols such as diethylene glycol, triethylene glycol, and tetraethylene glycol are preferable from the viewpoint of solubility in an electrolytic solution described later that is used in a dye-sensitized solar cell, and the effect of suppressing voltage loss.

Specific examples of the usable functional group-containing TEMPO compound include hydroxy TEMPO compounds such as 4-hydroxy TEMPO, 4-hydroxymethyl TEMPO, 4-(2-hydroxyethyl) TEMPO, 4-(3-hydroxypropyl) TEMPO, 4-(4-hydroxybutyl) TEMPO, 4-(5-hydroxypentyl) TEMPO, and 4-(6-hydroxyhexyl) TEMPO; carboxy TEMPO compounds such as 4-carboxy TEMPO, 4-carboxymethyl TEMPO, 4-(2-carboxyethyl) TEMPO, 4-(3-carboxypropyl) TEMPO, 4-(4-carboxybutyl) TEMPO, 4-(5-carboxypentyl) TEMPO, and 4-(6-carboxyhexyl) TEMPO; and halogen-containing TEMPO compounds such as 4-chloro TEMPO, 4-bromo TEMPO, 4-iodo TEMPO, 4-bromomethyl TEMPO, 4-(2-bromoethyl) TEMPO, 4-(3-bromopropyl) TEMPO, 4-(4-bromobutyl) TEMPO, 4-(5-bromopentyl) TEMPO, and 4-(6-bromohexyl) TEMPO.

For example, in the case where a dicarboxylic acid is used as a bifunctional compound, the compound having 2 TEMPO groups per molecule can be synthesized by esterifying sebacic acid and 4-hydroxy TEMPO using thionyl chloride. In addition, for example, in the case where a diol compound is used as a bifunctional compound, the compound having 2 TEMPO groups per molecule can be synthesized by esterifying 1,8-octanediol and 4-carboxy TEMPO using thionyl chloride.

Further, for example, the nitroxyl radical compound represented by the formula (3) that has 1 to 4 TEMPO groups per molecule can be synthesized by reacting a trifunctional compound or a tetrafunctional compound with a

functional group-containing TEMPO compound. A method for manufacturing the nitroxyl radical compound represented by the formula (3) is not particularly limited, and a known method can be adopted. For example, the nitroxyl radical compound represented by the formula (3) that has 1 to 4 TEMPO groups per molecule can be synthesized by reacting a halide of phosphorus or silicon, such as phosphorus trichloride or silicon tetrachloride, as a trifunctional compound or a tetrafunctional compound with an active hydrogen-containing TEMPO compound. More specifically, the nitroxyl radical compound represented by the formula (3) can be synthesized by reacting a phosphorus halide or a silicon halide having fluorine, chlorine, bromine, iodine or the like with an active hydrogen-containing TEMPO compound such as 4-hydroxy-TEMPO in the presence of a neutralizing agent such as triethylamine.

Specific examples of the trifunctional compound or the tetrafunctional compound include phosphorus halides such as phosphorus trifluoride, phosphorus trichloride, phosphorus tribromide, and phosphorus triiodide; and silicon halides such as silicon tetrafluoride, silicon tetrachloride, silicon tetrabromide, and silicon tetraiodide. Besides the phosphorus halide and silicon halide, halides of aluminum, boron, titanium, tin, antimony and the like can also be used. Among these halides, phosphorus trichloride, silicon tetrachloride and the like are preferable from the viewpoint of ease of availability.

The active hydrogen-containing TEMPO compound is not particularly limited as long as it is capable of reacting with the functional group of the trifunctional compound or tetrafunctional compound, and has a TEMPO group. The active hydrogen-containing TEMPO compound is preferably a hydroxyalkyl TEMPO compound such as 4-hydroxy TEMPO, 4-hydroxymethyl TEMPO, 4-(2-hydroxyethyl) TEMPO, 4-(3-hydroxypropyl) TEMPO, 4-(4-hydroxybutyl) TEMPO, 4-(5-hydroxypentyl) TEMPO, and 4-(6-hydroxyhexyl) TEMPO. Among them, 4-hydroxy TEMPO, 4-(2-hydroxyethyl) TEMPO, 4-(4-hydroxybutyl) TEMPO, and 4-(6-hydroxyhexyl) TEMPO are preferable from the viewpoint of the effect of suppressing voltage and current loss. One type of the active hydrogen-containing TEMPO compound may be used alone, or two or more types thereof may be used in combination.

The molecular weight of the nitroxyl radical compound can be measured by a known method. As a method for measuring the molecular weight, for example, general methods such as gel permeation chromatography (GPC) and mass spectrometry (MS) can be adopted. For example, in the case of the gel permeation chromatography, the number average molecular weight can be calculated by standard polystyrene conversion using, for example, 2695 and 2414 manufactured by Waters Corporation as a GPC apparatus, columns OH-pak SB-202.5 HQ and SB-203 HQ manufactured by SHOWDEX, and N,N-dimethylformamide as a mobile phase. Alternatively, in the case of mass spectrometry, for example, the molecular weight can be measured using, for example, LCMS-2010 EV system manufactured by Shimadzu Corporation as an MS apparatus. When the molecular weight of one compound can be measured by both the methods of gel permeation chromatography (GPC) and mass spectrometry (MS), the molecular weight refers to the value measured by mass spectrometry (MS).

The percentage (introduction rate) of the TEMPO group in the charge-transporting material (sample) formed of the nitroxyl radical compound can be confirmed by electron spin resonance (ESR) measurement. In the ESR, the spin intensity is obtained by using FR-30EX manufactured by JEOL as an ESR measuring apparatus, precisely weighing a compound having a known TEMPO group content, such as 4-hydroxy TEMPO or 4-acetamide TEMPO, as a reference specimen in a quartz glass tube, measuring the spin signal by ESR measurement, and then integrating the resulting value twice. Meanwhile, a quartz glass tube is filled with a weighed sample, and the spin intensity is similarly determined by ESR measurement. Then, the percentage (introduction rate) of the TEMPO group in the charge-transporting material can be calculated by comparing the spin intensity ratio and the molar ratio of charged sample between the reference specimen and the sample.

$$\text{Percentage of TEMPO group in sample (mol\%)} = (B)/(A)/\text{number of TEMPO groups per molecule} \times 100$$

(A) Spin intensity of reference specimen/mol

(B) Spin intensity of sample/mol

In the electrolytic solution for a dye-sensitized solar cell of the present invention, the use ratio between the nitroxyl radical compound and the sulfone compound of the formula (1) is not particularly limited. However, the concentration of the charge-transporting material (nitroxyl radical compound) in the electrolytic solution containing the sulfone compound as a solvent is preferably about 0.01 to 5 M, more preferably about 0.05 to 1 M from the viewpoint of improving cell characteristics. Herein, "M" means mol/L.

In the present invention, the charge-transporting material may be formed of only one type of nitroxyl radical compound, or may be formed of two or more types of nitroxyl radical compounds. Moreover, a combination of the nitroxyl radical compound represented by the formula (2) or (3) and an additional charge-transporting material may be used as

the charge-transporting material. The additional charge-transporting material is not particularly limited, and may be a non-iodine-based or iodine-based charge-transporting material.

The electrolytic solution of the present invention may contain additives such as a viscosity adjusting agent and a pH adjusting agent. One type of additive may be used alone, or two or more types thereof may be used in combination.

The charge-transporting material used in the present invention is non-iodine-based, excellent in diffusibility in an electrolytic solution, and further effectively suppressed in the reverse electron transfer reaction with a semiconductor. Therefore, the electrolytic solution of the present invention containing the combination of the charge-transporting material and the above-mentioned solvent can be suitably used as an electrolytic solution for an electrolyte layer of a dye-sensitized solar cell as described later, for example.

2. Dye-sensitized solar cell

The dye-sensitized solar cell of the present invention includes a semiconductor electrode containing a semiconductor and a dye, a counter electrode opposed to the semiconductor electrode, and an electrolyte layer provided between the semiconductor electrode and the counter electrode, and the electrolyte layer contains a nitroxyl radical compound, and a sulfone compound represented by the following formula (1):

[Chemical Formula 12]

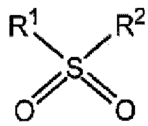

(1)

wherein $R^1$ and $R^2$ are each independently a linear or branched alkyl group having 1 to 12 carbon atoms, an alkoxy group, an aromatic ring, or a halogen, or $R^1$ and $R^2$ are mutually linked to form a cyclic sulfone compound. That is, for the electrolyte layer of the dye-sensitized solar cell of the present invention, the above-mentioned electrolytic solution of the present invention can be suitably used. Details of the electrolytic solution used in the electrolyte layer of the dye-sensitized solar cell of the present invention are as described in the item of "1. Electrolytic solution for dye-sensitized solar cell".

In the dye-sensitized solar cell of the present invention, use of the electrolytic solution of the present invention (that is, the electrolytic solution containing the specific nitroxyl radical compound as a charge-transporting material and the specific sulfone compound as a solvent) in the electrolyte layer makes the dye-sensitized solar cell inexpensive, excellent in diffusibility of a charge-transporting material although the electrolytic solution is non-iodine-based, and being stabilized in cell characteristics over a long period of time. Furthermore, since the dye-sensitized solar cell includes a non-iodine-based charge-transporting material, there is no need to use an expensive metal such as platinum in a current collector or the like, so that a less expensive dye-sensitized solar cell can be provided.

As the semiconductor electrode, those used in a known dye-sensitized solar cell can be used. For example, a semiconductor electrode can be obtained by applying a semiconductor to a glass or plastic electrode plate subjected to conductive treatment with tin or zinc-doped indium oxide (ITO or IZO) or the like to form a semiconductor layer, then baking the semiconductor layer at a high temperature, and chemically adsorbing a dye to the surface of the semiconductor layer.

As the semiconductor, those used in a known dye-sensitized solar cell can be employed. Examples of the preferable semiconductor include porous metal oxides formed of oxides of titanium, zinc, niobium, tin, vanadium, indium, tungsten, tantalum, zirconium, molybdenum, manganese, iron, copper, nickel, iridium, rhodium, chromium, ruthenium and the like. One type of semiconductor may be used alone, or two or more types thereof may be used in combination.

As the dye to be adsorbed to the semiconductor layer, those used in a known dye-sensitized solar cell can be employed. Examples of the preferable dye include a ruthenium complex dye. Specific examples of the ruthenium complex dye include N3, black dye, a bipyridine-carboxylic acid group, a bipyridine dye, phenanthroline, quinoline, and a β-diketonate complex. In addition to the ruthenium complex dye, metal complex dyes such as Os metal complex, Fe metal complex, Cu metal complex, Pt metal complex, and Re metal complex, methine dyes such as cyanine dyes and merocyanine dyes, and organic dyes such as mercurochrome dyes, xanthene dyes, porphyrin dyes, phthalocyanine dyes, cyanidin dyes, rhodamine dyes, azo dyes, and coumarin dyes can also be used. One type of dye may be used alone, or two or more types thereof may be used in combination.

As a counter electrode opposed to the semiconductor electrode, those used in a known dye-sensitized solar

cell can be used. For example, a glass or plastic electrode plate coated with platinum, conductive carbon or the like as a conductive agent can be used. Further, since the dye-sensitized solar cell of the present invention includes a non-iodine-based charge-transporting material as the electrolyte, aluminum, copper or the like can also be used as the material of the counter electrode.

EXAMPLES

Hereinafter, the present invention will be described in detail with reference to examples and comparative examples. However, the present invention is not limited to these examples. The molecular weight of the compounds obtained in the production examples was measured by mass spectrometry (atmospheric pressure ionization method) using LCMS-2010 EV system manufactured by Shimadzu Corporation. However, the molecular weight of the compound of Comparative Example 1 is the number average molecular weight measured by gel permeation chromatography. Specifically, the number average molecular weight was calculated by standard polystyrene conversion using, for example, 2695 and 2414 manufactured by Waters Corporation as a GPC apparatus, columns OH-pak SB-202.5 HQ and SB-203 HQ manufactured by SHOWDEX, and N,N-dimethylformamide as a mobile phase. The introduction rate of the TEMPO group (radical unit) was calculated according to the same method as the above-mentioned ESR measurement method through comparison of the spin intensity ratio and the molar ratio of charged sample between the reference specimen and the sample by electron spin resonance (ESR) measurement using FR-30EX manufactured by JEOL as an ESR measuring apparatus, and 4-hydroxy TEMPO as the reference specimen.

[Production Example 1] Synthesis of bis(2,2,6,6-tetramethyl-4-piperidyl-1-oxyl) sebacate (compound (A))

[Chemical Formula 13]

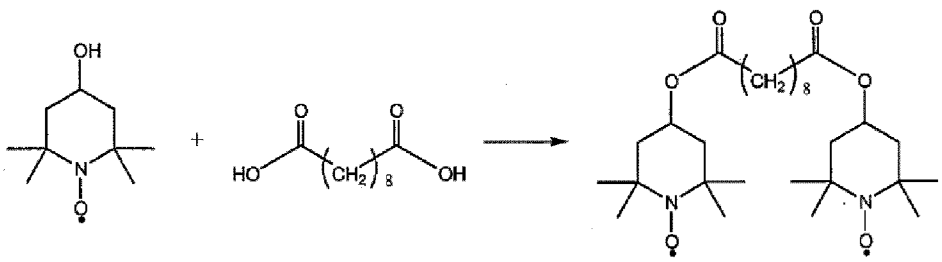

(A)

A 200 mL four-necked flask equipped with a stirrer, a nitrogen gas inlet tube, a thermometer, and a reflux condenser tube was thoroughly aerated with nitrogen, and then 50 mL of tetrahydrofuran, 1.11 g (0.011 mol) of triethylamine, and 1.72 g (0.010 mol) of 4-hydroxy-2,2,6,6-tetramethylpiperidine (manufactured by Tokyo Chemical Industry Co., Ltd., trade name: TEMPOL) were charged into the flask to give a homogeneous solution. Then, after cooling the four-necked flask to 10°C or lower with ice water, 20 mL of a tetrahydrofuran solution containing 1.01 g (0.005 mol) of sebacic acid (manufactured by Tokyo Chemical Industry Co., Ltd.) and 1.31 g (0.011 mol) of thionyl chloride was added dropwise continuously to the homogeneous solution. After completion of the dropwise addition, the reaction liquid was reacted for 2 hours while being kept at 10°C or lower, and then the reaction was continued at room temperature for another 2 hours. Then, the reaction liquid was filtered, water was added to the reaction liquid, and extraction with diethyl ether was repeated several times. Further, the ether was removed with an evaporator, and the obtained reaction product was subjected to column purification with hexane-chloroform to give 2.18 g of a reddish brown solid. The obtained product had a molecular weight of 510 as measured by mass spectrometry, and was bis(2,2,6,6-tetramethyl-4-piperidyl-1-oxyl) sebacate (compound (A) of the above-mentioned formula). Further, the introduction rate of the TEMPO group (radical unit) obtained through the ESR measurement was 98 mol%.

[Production Example 2] Synthesis of bis(6-(2,2,6,6-tetramethyl-4- piperidyl -1-oxyl)hexyl) sebacate (compound (B))

[Chemical Formula 14]

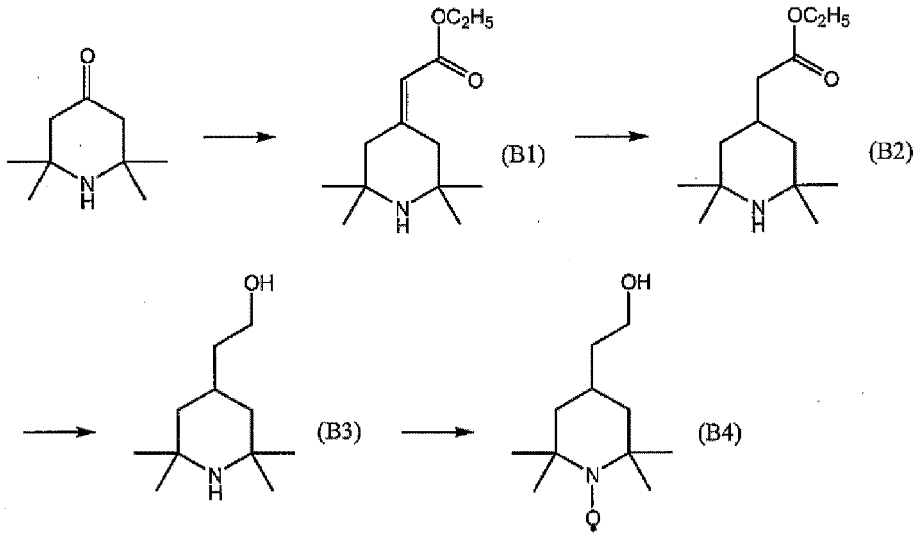

(B1)

(B2)

(B3)

(B4)

(Production Example 2-1) Intermediate (B1): Synthesis of ethyl (2,2,6,6-tetramethyl-4-piperidylidene) acetate

A 500 mL four-necked flask equipped with a stirrer, a nitrogen gas inlet tube, a thermometer, and a reflux condenser tube was thoroughly aerated with nitrogen, then 4.0 g (0.10 mol) of sodium hydride and 100 mL of diethyl ether were mixed, and 25.1 g (0.11 mol) of triethyl phosphonoacetate was slowly added to the flask. Then, 80 mL of a diethyl ether solution of 10.9 g (0.07 mol) of 2,2,6,6-tetramethyl-4-piperidone was slowly added, and the reaction was continued for 15 hours. Subsequently, water was added to the reaction product, extraction with diethyl ether was repeated several times, the reaction product was dehydrated with magnesium sulfate, and the solvent was removed with an evaporator to give 8.7 g (0.039 mol) of the intermediate (B1). The obtained product had a molecular weight of 225 as measured by mass spectrometry, and was confirmed to be ethyl (2,2,6,6-tetramethyl-4-piperidylidene) acetate (intermediate (B1) of the above-mentioned formula).

(Production Example 2-2) Intermediate (B2): Synthesis of ethyl (2,2,6,6-tetramethyl-4-piperidyl) acetate

A 500 mL four-necked flask equipped with a stirrer, a nitrogen gas inlet tube, a thermometer, and a reflux condenser tube was thoroughly aerated with nitrogen, and then 8.7 g (0.039 mol) of the intermediate (B1) was added to 120 mL of ethyl alcohol and dissolved therein. Subsequently, 0.8 g of 10% palladium/carbon was added to the solution, and the inside of the reaction vessel was filled with hydrogen gas with stirring. After 1 hour, the reaction was continued at 60°C for 4 hours. After cooling, the reaction liquid was filtered, and the solvent was removed from the resulting filtrate with an evaporator to give 8.6 g (0.038 mol) of the intermediate (B2). The obtained product had a molecular weight of 227 as measured by mass spectrometry, and was confirmed to be ethyl (2,2,6,6-tetramethyl-4-piperidyl) acetate (intermediate (B2) of the above-mentioned formula).

(Production Example 2-3) Intermediate (B3): Synthesis of 2-(2,2,6,6-tetramethyl-4-piperidyl) ethanol

A 500 mL four-necked flask equipped with a stirrer, a nitrogen gas inlet tube, a thermometer, and a reflux condenser tube was thoroughly aerated with nitrogen, then 46 mL of a 1 M lithium aluminum hydride/diethyl ether solution was added, then a solution of 8.6 g (0.038 mol) of the intermediate (B2) in 100 mL of diethyl ether was slowly added, and the reaction was continued for 1 hour. Subsequently, the reaction was stopped by slowly adding water, extraction with a mixed liquid of diethyl ether/chloroform was repeated several times, the reaction product was dehydrated with magnesium sulfate, and the solvent was removed with an evaporator to give 6.8 g (0.037 mol) of the intermediate (B3). The obtained product had a molecular weight of 185 as measured by mass spectrometry, and was confirmed to be 2-(2,2,6,6-tetramethyl-4-piperidyl) ethanol (intermediate (B3) of the above-mentioned formula).

(Production Example 2-4) Intermediate (B4): Synthesis of 2-(2,2,6,6-tetramethyl-4-piperidyl-1-oxyl) ethanol

To a 500 mL four-necked flask equipped with a stirrer, a nitrogen gas inlet tube, a thermometer, and a reflux condenser tube, 6.8 g (0.037 mol) of the intermediate (B3), 145 mL of water, 16.3 mL (0.19 mol) of 35% hydrogen peroxide water, 50 mL of diethyl ether, 0.6 g (0.015 mol) of disodium ethylenediaminetetraacetate, and 0.6 g (0.02 mol) of sodium tungstate were added, and the reaction was continued at room temperature for 24 hours. Subsequently, the ether layer was extracted with chloroform, washed repeatedly several times with water, and dehydrated with magnesium sulfate, and the solvent was removed with an evaporator to give 4.9 g (0.024 mol) of the intermediate (B4). The obtained product had a molecular weight of 200 as measured by mass spectrometry, and was confirmed to be 2-(2,2,6,6-tetramethyl-4-piperidyl-1-oxyl) ethanol (intermediate (B4) of the above-mentioned formula).

[Chemical Formula 15]

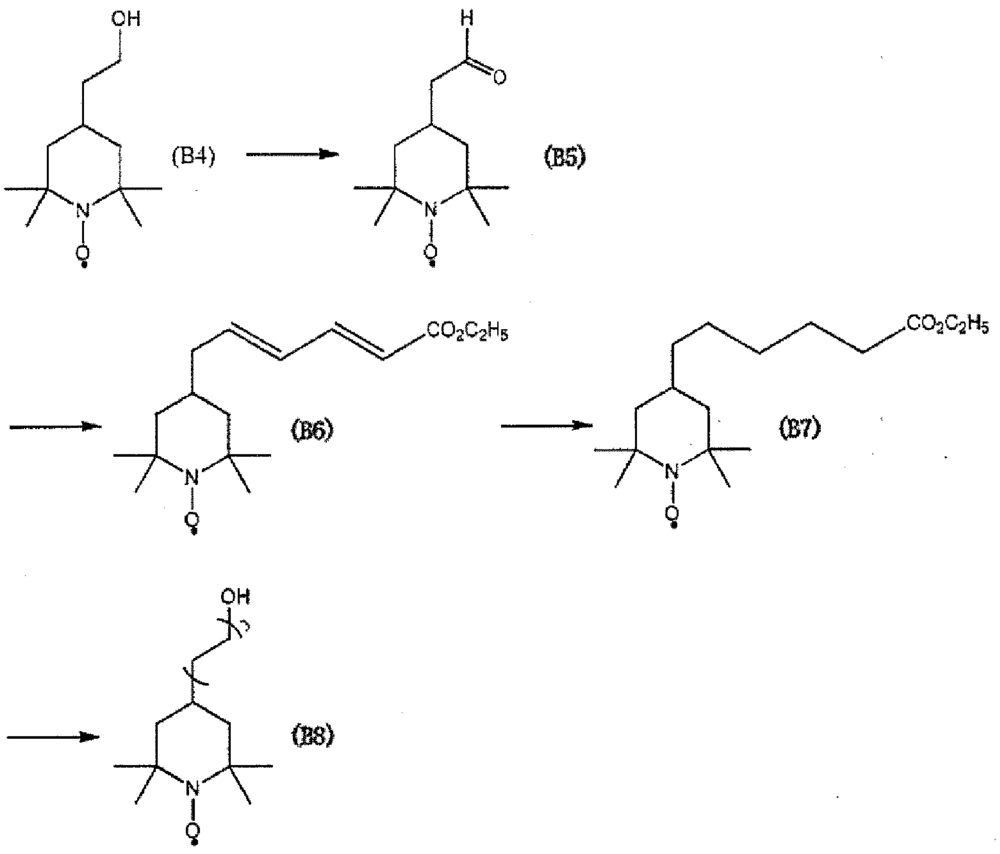


(Production Example 2-5) Intermediate (B5): Synthesis of 2-(2,2,6,6-tetramethyl-4-piperidyl-1-oxyl) acetaldehyde

To a 1,000 mL four-necked flask equipped with a stirrer, a nitrogen gas inlet tube, a thermometer, and a reflux condenser tube, 22.8 g (0.114 mol) of the intermediate (B4), 80.0 g (0.230 mol) of pyridinium dichromate, and 200 mL of dichloromethane were added, and the reaction was continued for 10 hours with stirring. Subsequently, 300 mL of diethyl ethanol was added, filtration washing was carried out, and the solvent was removed with an evaporator to give a crude product. The resulting crude product was subjected to silica gel column purification with a hexane-chloroform developing solution to give 14.7 g (0.074 mol) of the intermediate (B5). The obtained product had a molecular weight of 198 as measured by mass spectrometry, and was confirmed to be 2-(2,2,6,6-tetramethyl-4-piperidyl-1-oxyl) acetaldehyde (intermediate (B5) of the above-mentioned formula).

(Production Example 2-6) Intermediate (B6): Synthesis of methyl-6-(2,2,6,6-tetramethyl-4-piperidyl-1-oxyl) hexa-2,4-dienoate

A 500 mL four-necked flask equipped with a stirrer, a nitrogen gas inlet tube, a thermometer, and a reflux

condenser tube was thoroughly aerated with nitrogen, then 4.1 g (0.103 mol) of sodium hydride and 300 mL of diethyl ether were mixed, and 29.4 g (0.117 mol) of triethylphosphonocrotonate was slowly added to the flask. Then, 100 mL of a diethyl ether solution of 14.7 g (0.074 mol) of the intermediate (B5) was slowly added, and the reaction was continued for 15 hours. Subsequently, water was added to the reaction product, extraction with diethyl ether was repeated several times, the reaction product was dehydrated with magnesium sulfate, and the solvent was removed with an evaporator to give 13.9 g (0.047 mol) of the intermediate (B6). The obtained product had a molecular weight of 294 as measured by mass spectrometry, and was confirmed to be methyl-6-(2,2,6,6-tetramethyl-4-piperidyl-1-oxyl) hexa-2,4-dienoate (intermediate (B6) of the above-mentioned formula).

(Production Example 2-7) Intermediate (B7): Synthesis of methyl-6-(2,2,6,6-tetramethyl-4-piperidyl-1-oxyl) hexanoate

A 500 mL four-necked flask equipped with a stirrer, a nitrogen gas inlet tube, a thermometer, and a reflux condenser tube was thoroughly aerated with nitrogen, and then 13.9 g (0.047 mol) of the intermediate (B6) was added to 200 mL of ethyl alcohol and dissolved therein. Subsequently, 1.4 g of 10% palladium/carbon was added to the solution, and the inside of the reaction vessel was filled with hydrogen gas with stirring. After 1 hour, the reaction was continued at 60°C for 4 hours. After cooling, the reaction liquid was filtered, and the solvent was removed from the resulting filtrate with an evaporator to give 7.4 g (0.025 mol) of the intermediate (B7). The obtained product had a molecular weight of 298 as measured by mass spectrometry, and was confirmed to be methyl-6-(2,2,6,6-tetramethyl-4-piperidyl-1-oxyl) hexanoate (intermediate (B7) of the above-mentioned formula).

(Production Example 2-8) Intermediate (B8): Synthesis of 2-(2,2,6,6-tetramethyl-4-piperidyl-1-oxyl) hexanol

A 500 mL four-necked flask equipped with a stirrer, a nitrogen gas inlet tube, a thermometer, and a reflux condenser tube was thoroughly aerated with nitrogen, then 53 mL of a 1 M lithium aluminum hydride/diethyl ether solution was added, then a solution of 7.4 g (0.025 mol) of the intermediate (B7) in 200 mL of diethyl ether was slowly added, and the reaction was continued for 1 hour. Subsequently, the reaction was stopped by slowly adding water, extraction with a mixed liquid of diethyl ether/chloroform was repeated several times, the reaction product was dehydrated with magnesium sulfate, and the solvent was removed with an evaporator to give 4.4 g (0.017 mol) of the intermediate (B8). The obtained product had a molecular weight of 256 as measured by mass spectrometry, and was confirmed to be 2-(2,2,6,6-tetramethyl-4-piperidyl) hexanol (intermediate (B8) of the above-mentioned formula).

(Production Example 2-9) Compound (B): Synthesis of bis(6-(2,2,6,6-tetramethyl-4-piperidyl-1-oxyl)hexyl) sebacate

[Chemical Formula 16]

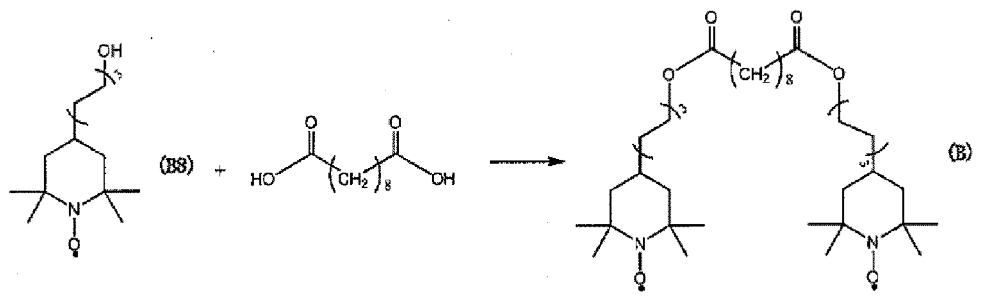

The procedure of Example 2-5 was repeated except that 2.6 g (0.010 mol) of the intermediate (B8) was used instead of 4-hydroxy-2,2,6,6-tetramethylpiperidine in Production Example 1 to give 3.9 g of a product. The obtained product had a molecular weight of 678 as measured by mass spectrometry, and was confirmed to be bis(6-(2,2,6,6-tetramethyl-4-piperidyl-1-oxyl)hexyl) sebacate (0.006 mol) (compound (B) of the above-mentioned formula). Further, the introduction rate of the TEMPO group (radical unit) obtained through the ESR measurement was 99 mol%.

[Production Example 3] Synthesis of tris(2,2,6,6-tetramethylpiperidin-4-yl-1-oxyl) phosphite (compound (C))

[Chemical Formula 17]

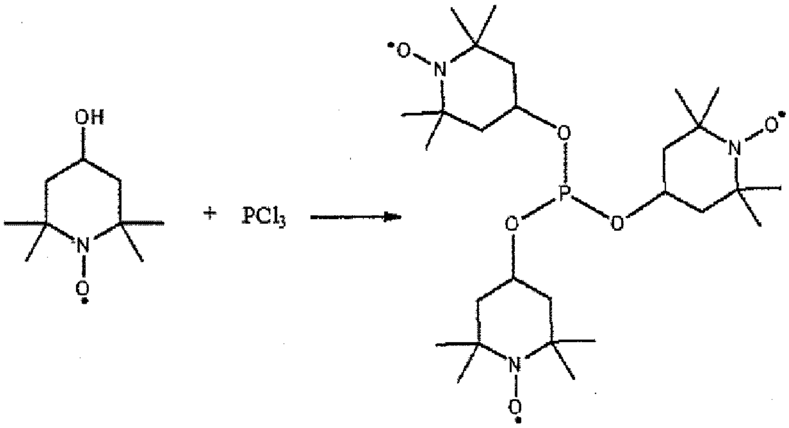


(C)

A 100 mL four-necked flask equipped with a stirrer, a nitrogen gas inlet tube, a thermometer, and a reflux condenser tube connected with a calcium chloride tube was thoroughly aerated with nitrogen, then 3 g (17.4 mmol) of 4-hydroxy TEMPO, 1.8 g (17.7 mmol) of triethylamine, and 20 mL of chloroform were added to the flask and dissolved, and then the solution was cooled to 10°C or lower. Subsequently, a mixed liquid of 0.8 g (5.8 mmol) of phosphorus trichloride and 10 mL of chloroform was slowly added from a 50 mL dropping funnel and continuously stirred for 2 hours, and then the reaction was continued at room temperature for another 14 hours. Subsequently, triethylamine hydrochloride was removed by filtration, and the solvent was removed from the resulting filtrate with an evaporator. Then, 2.9 g of the resulting crude product was subjected to column purification using chloroform as a developing solution and using silica gel to give a product. The obtained product had a molecular weight of 544 as measured by mass spectrometry, and was confirmed to be 2.1 g (yield 66%) of tris(2,2,6,6-tetramethylpiperidin-4-yl-1-oxyl) phosphite (compound (C) of the above-mentioned formula). Further, the introduction rate of the TEMPO group (radical unit) obtained through the ESR measurement was 99 mol%.

[Production Example 4] Synthesis of tetrakis(2,2,6,6-tetramethylpiperidin-4-yl-1-oxyl) orthosilicate (compound (D))

[Chemical Formula 18]

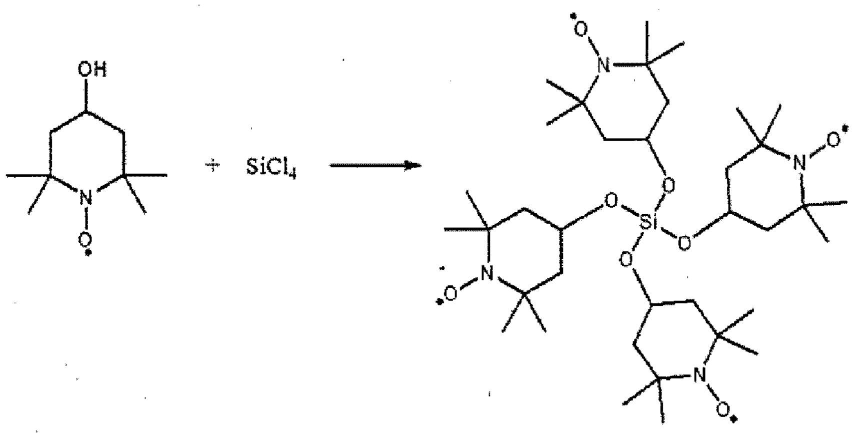

(D)

A 100 mL four-necked flask equipped with a stirrer, a nitrogen gas inlet tube, a thermometer, and a reflux condenser tube connected with a calcium chloride tube was thoroughly aerated with nitrogen, then 3.5 g (20.3 mmol) of 4-hydroxy TEMPO, 2.7 g (26.7 mmol) of triethylamine, and 20 mL of chloroform were added to the flask and dissolved, and then the solution was cooled to 10°C or lower. Subsequently, a mixed liquid of 0.74 g (4.1 mmol) of silicon tetrachloride and 10 mL of chloroform was slowly added from a 50 mL dropping funnel and continuously stirred for 1 hour, and then the reaction was continued at room temperature for another 4 hours. Subsequently, triethylamine hydrochloride was removed by filtration, and the solvent was removed from the resulting filtrate with an evaporator. Then, 2.4 g of the resulting crude product was subjected to column purification using chloroform as a developing solution and using silica gel to give a product. The obtained product had a molecular weight of 712 as measured by mass spectrometry, and was confirmed to be 1.8 g (yield 58%) of tetrakis(2,2,6,6-tetramethylpiperidin-4-yl-1-oxyl) orthosilicate (compound (D) of the above-mentioned formula). Further, the introduction rate of the TEMPO group (radical unit) obtained through the ESR measurement was 99 mol%.

[Preparation of Dye-Sensitized Solar Cell and Evaluation of Cell Characteristics]

(Example 1)

To a glass substrate (ITO) containing tin oxide as a conductive agent, a dispersion liquid of titanium oxide as a semiconductor was applied, and the substrate was baked at 450°C. Subsequently, the glass substrate was immersed in acetonitrile containing D205 (manufactured by Mitsubishi Paper Mills Limited) as a dye at room temperature to adsorb the dye to the substrate, whereby a semiconductor electrode containing a semiconductor and a dye was obtained. Then, a counter electrode containing vapor-deposited platinum and a semiconductor electrode were disposed at an interval of 0.5 mm to form a cell, an electrolytic solution obtained by dissolving the compound (A) synthesized in Production Example 1 in a 0.1 M lithium bistrifluoromethanesulfonylimide/ethyl isopropyl sulfone solution was added to the cell, and the cell was sealed with a photocurable resin to give a dye-sensitized solar cell. Using a white bias light source, the initial current density ($mA/cm^2$) and open circuit voltage (mV) were measured using a spectral sensitivity measuring device (CEP-2000 manufactured by Bunkoukeiki Co., Ltd.), then the cell was allowed to stand still at room temperature for 3 months, and the current density and the open circuit voltage were similarly measured. The results are shown in Table 1. The concentration of the charge-transporting material in the electrolytic solution was adjusted to 0.1 M.

(Example 2)

A dye-sensitized solar cell was produced in the same manner as in Example 1 except that ethyl isobutyl sulfone was used instead of ethyl isopropyl sulfone to prepare an electrolytic solution, and the current density and open circuit voltage were measured. The results are shown in Table 1. The concentration of the charge-transporting material in the electrolytic solution was adjusted to 0.1 M.

(Example 3)

A dye-sensitized solar cell was produced in the same manner as in Example 1 except that isopropyl isobutyl sulfone was used instead of ethyl isopropyl sulfone to prepare an electrolytic solution, and the current density and open

circuit voltage were measured. The results are shown in Table 1. The concentration of the charge-transporting material in the electrolytic solution was adjusted to 0.1 M.

(Example 4)

A dye-sensitized solar cell was produced in the same manner as in Example 1 except that the compound (B) synthesized in Production Example 2 was used instead of the compound (A) as a charge-transporting material to prepare an electrolytic solution, and the current density and open circuit voltage were measured. The results are shown in Table 1. The concentration of the charge-transporting material in the electrolytic solution was adjusted to 0.1 M.

(Example 5)

A dye-sensitized solar cell was produced in the same manner as in Example 1 except that the compound (C) synthesized in Production Example 3 was used instead of the compound (A) as a charge-transporting material to prepare an electrolytic solution, and the current density and open circuit voltage were measured. The results are shown in Table 1. The concentration of the charge-transporting material in the electrolytic solution was adjusted to 0.07 M.

(Example 6)

A dye-sensitized solar cell was produced in the same manner as in Example 1 except that the compound (D) synthesized in Production Example 4 was used instead of the compound (A) as a charge-transporting material to prepare an electrolytic solution, and the current density and open circuit voltage were measured. The results are shown in Table 1. The concentration of the charge-transporting material in the electrolytic solution was adjusted to 0.05 M.

(Comparative Example 1)

A dye-sensitized solar cell was produced in the same manner as in Example 1 except that iodine was used instead of the compound (A) as a charge-transporting material to prepare an electrolytic solution, and the current density and open circuit voltage were measured. The results are shown in Table 1. The concentration of the charge-transporting material in the electrolytic solution was adjusted to 0.2 M.

(Comparative Example 2)

A dye-sensitized solar cell was produced in the same manner as in Example 1 except that acetonitrile was used instead of ethyl isopropyl sulfone to prepare an electrolytic solution, and the current density and open circuit voltage were measured. The results are shown in Table 1. The concentration of the charge-transporting material in the electrolytic solution was adjusted to 0.1 M.

[Table 1]

| | Solvent | Charge-transporting material | Initial | | After standing still | |
|---|---|---|---|---|---|---|
| | | (Compound) | Current density (mA/cm$^2$) | Open circuit voltage (mV) | Current density (mA/cm$^2$) | Open circuit voltage (mV) |
| Example 1 | Ethyl isopropyl sulfone | A | 4.8 | 810 | 4.7 | 800 |
| Example 2 | Ethyl isobutyl sulfone | A | 4.6 | 810 | 4.4 | 800 |
| Example 3 | Isopropyl isobutyl sulfone | A | 4.5 | 810 | 4.3 | 800 |

(continued)

| | Solvent | Charge-transporting material | Initial | | After standing still | |
|---|---|---|---|---|---|---|
| | | (Compound) | Current density (mA/cm$^2$) | Open circuit voltage (mV) | Current density (mA/cm$^2$) | Open circuit voltage (mV) |
| Example 4 | Ethyl isopropyl sulfone | B | 6.7 | 800 | 6.6 | 790 |
| Example 5 | Ethyl isopropyl sulfone | C | 4.9 | 730 | 4.7 | 720 |
| Example 6 | Ethyl isopropyl sulfone | D | 5 | 720 | 4.7 | 700 |
| Comparative Example 1 | Ethyl isopropyl sulfone | Iodine | 7.3 | 480 | 4.5 | 400 |
| Comparative Example 2 | Acetonitrile | A | 4.5 | 810 | 1.5 | 750 |

As shown in Table 1, in the dye-sensitized solar cells of Examples 1 to 6 that contained a sulfone compound as a solvent and a nitroxyl radical compound as a charge-transporting material, both the current density and the open circuit voltage were high, and the current density and the open circuit voltage after the cells were allowed to stand still were almost the same values as the initial values.

In the dye-sensitized solar cell of Comparative Example 1 that contained iodine as a charge-transporting material, both the current density and the open circuit voltage greatly decreased after the cell was allowed to stand still as compared with the initial values. The reason is speculated as follows: since iodine has sublimation property, iodine is released from the electrolyte layer while the cell is allowed to stand still, and consequently it becomes difficult to sufficiently transport charge, leading to a decrease in current density and open circuit voltage.

Furthermore, in the dye-sensitized solar cell of Comparative Example 2 that contained acetonitrile as a solvent, both the current density and the open circuit voltage greatly decreased after the cell was allowed to stand still as compared with the initial values. The reason is speculated as follows: acetonitrile as the solvent evaporated to make it difficult to transport charge due to precipitation of the charge-transporting material or the like, leading to a decrease in current density and open circuit voltage.

## Claims

**1.** A dye-sensitized solar cell comprising:

a semiconductor electrode containing a semiconductor and a dye,
a counter electrode opposed to the semiconductor electrode, and
an electrolyte layer provided between the semiconductor electrode and the counter electrode,
wherein the electrolyte layer contains a nitroxyl radical compound, and a sulfone compound represented by the following formula (1):

[Chemical Formula 1]

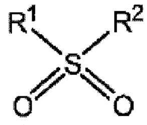

(1)

wherein $R^1$ and $R^2$ are each independently a linear or branched alkyl group having 1 to 12 carbon atoms, an alkoxy group, an aromatic ring, or a halogen, or $R^1$ and $R^2$ are mutually linked to form a cyclic sulfone compound.

**2.** The dye-sensitized solar cell according to claim 1, wherein the nitroxyl radical compound is a nitroxyl radical compound represented by the following formula (2):

[Chemical Formula 2]

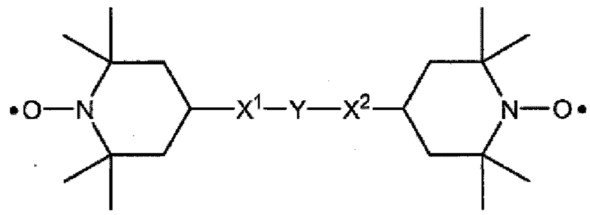

(2)

wherein $X^1$ represents a group $-(CH_2)_{n1}-OC(=O)-$, a group $-(CH_2)_{n1}-C(=O)O-$, or a group -O-, $X^2$ represents a group $-C(=O)O-(CH_2)_{n2}-$, a group $-OC(=O)-(CH_2)_{n2}-$, or a group -O-, n1 and n2 each independently represent an integer of 0 to 10, Y represents a group $-(CH_2)_{n3}-$ or a group $-(CH_2CH_2O)_{n4}-CH_2CH_2-$, and n3 and n4 each represent an integer of 0 to 22.

**3.** The dye-sensitized solar cell according to claim 2, wherein the nitroxyl radical compound represented by the formula (2) has a molecular weight of 380 or more.

**4.** The dye-sensitized solar cell according to claim 2 or 3, wherein, in the formula (2), $X^1$ represents a group $-(CH_2)_{n1}-OC(=O)-$, $X^2$ represents a group $-C(=O)O-(CH_2)_{n2}-$, Y represents a group $-(CH_2)_{n3}-$, n1 and n2 each independently represent an integer of 0 to 10, and n3 represents an integer of 0 to 22.

**5.** The dye-sensitized solar cell according to claim 2 or 3, wherein, in the formula (2), $X^1$ represents a group $-(CH_2)_{n1}-C(=O)O-$, $X^2$ represents a group $-OC(=O)-(CH_2)_{n2}-$, Y represents a group $-(CH_2CH_2O)_{n4}-CH_2CH_2-$, n1 and n2 each independently represent an integer of 0 to 10, and n4 represents an integer of 1 to 22.

**6.** The dye-sensitized solar cell according to claim 1, wherein the nitroxyl radical compound is a nitroxyl radical compound represented by the following formula (3):

[Chemical Formula 3]

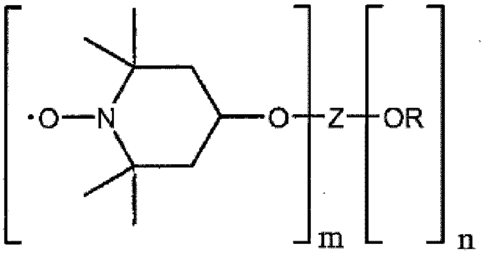

(3)

wherein Z represents a P atom or a Si atom, and n number of R's each independently represent an H atom, an alkyl group having 1 to 18 carbon atoms, or a 2,2,6,6-tetramethylpiperidine-1-oxyl-4-yl group, m represents an integer of 1 to 4, n represents an integer of 0 to 3, and when Z is a P atom, n + m = 3, and when Z is a Si atom, n + m = 4.

**7.** The dye-sensitized solar cell according to claim 6, wherein, in the formula (3), Z is a P atom and m is 3.

**8.** The dye-sensitized solar cell according to claim 6, wherein, in the formula (3), Z is a Si atom, m is 3 or 4, and when m is 3, R is an H atom.

**9.** An electrolytic solution for a dye-sensitized solar cell, comprising:

a nitroxyl radical compound, and
a sulfone compound represented by the following formula (1):

[Chemical Formula 4]

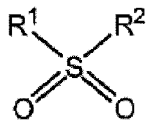

(1)

wherein $R^1$ and $R^2$ are each independently a linear or branched alkyl group having 1 to 12 carbon atoms, an alkoxy group, an aromatic ring, or a halogen, or $R^1$ and $R^2$ are mutually linked to form a cyclic sulfone compound.

## INTERNATIONAL SEARCH REPORT

International application No.
PCT/JP2016/062453

A. CLASSIFICATION OF SUBJECT MATTER
*H01G9/20*(2006.01)i

According to International Patent Classification (IPC) or to both national classification and IPC

B. FIELDS SEARCHED

Minimum documentation searched (classification system followed by classification symbols)
H01G9/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| Y<br>A | WO 2011/093253 A1 (Japan Carlit Co., Ltd.), 04 August 2011 (04.08.2011), claims; examples & US 2012/0301992 A1 claims; examples & EP 2530779 A1 & CN 102725905 A & KR 10-2012-0130101 A | 1-2,9<br>3-8 |
| Y<br>A | JP 2009-76369 A (ADEKA Corp.), 09 April 2009 (09.04.2009), claims; examples; paragraph [0023] (Family: none) | 1-2,9<br>3-8 |
| A | JP 2008-282632 A (Kyoto University), 20 November 2008 (20.11.2008), claims; examples (Family: none) | 1-9 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
01 July 2016 (01.07.16)

Date of mailing of the international search report
12 July 2016 (12.07.16)

Name and mailing address of the ISA/
Japan Patent Office
3-4-3,Kasumigaseki,Chiyoda-ku,
Tokyo 100-8915,Japan

Authorized officer

Telephone No.

Form PCT/ISA/210 (second sheet) (January 2015)

**INTERNATIONAL SEARCH REPORT**

International application No.
PCT/JP2016/062453

C (Continuation). DOCUMENTS CONSIDERED TO BE RELEVANT

| Category* | Citation of document, with indication, where appropriate, of the relevant passages | Relevant to claim No. |
|---|---|---|
| A | JP 2014-86239 A (NEC Corp.), 12 May 2014 (12.05.2014), claims; examples (Family: none) | 1-9 |
| A | JP 2012-164509 A (Japan Carlit Co., Ltd.), 30 August 2012 (30.08.2012), claims; examples (Family: none) | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 1220380 A
- JP 2010508636 A
- JP 2000285974 A
- JP 2001035551 A
- JP 2002363418 A
- JP 2009076369 A


### Non-patent literature cited in the description


- **GRATZEL et al.** *Ecole Polytechnique Federale de Lausanne,* 1991
- **B. O'REGAN ; M. GRATZEL.** *Nature,* 1991, vol. 353 (24), 737